# EUROPEAN PATENT SPECIFICATION

(11) **EP 4 012 480 B1**
(45) Date of publication and mention of the grant of the patent: **07.10.2026**
(21) Application number: 21213295.5
(22) Date of filing: 08.08.2016
(51) Int. Cl.: G02B 26/08, G02B 26/10, G02B 27/01, H04N 3/08, H04N 9/31

(54) **HEAD-MOUNTED DEVICE COMPRISING A PROJECTOR CONFIGURED TO PROJECT AN IMAGE**
AM KOPF MONTIERTES GERÄT MIT EINEM PROJEKTOR ZUM PROJIZIEREN EINES BILDES
DISPOSITIF MONTÉ SUR LA TÊTE COMPRENANT UN PROJECTEUR CONÇU POUR PROJETER UNE IMAGE

(43) Date of publication of application: 15.06.2022
(62) Document number(s) of the earlier application(s) in accordance with Art. 76 EPC: 16306029.6 / 3 281 909
(73) Proprietor: Essilor International, 94220 Charenton-Le-Pont (FR)
(72) Inventor: ROUSSEAU, Denis, 94220 Charenton-Le-Pont (FR)
(74) Representative: Cabinet Novitech

(56) References cited:
- WO-A1-2016/105283
- US-A- 5 715 021
- US-A1- 2013 207 964
- US-A1- 2013 208 362
- US-A1- 2015 126 857
- US-A1- 2016 212 888

## Description

### FIELD OF THE INVENTION

The inventions relates to a head mounted device comprising at least one projector configured to be embedded into an optical system of the head mounted device and to project an image through a back face of the optical system towards an eye of a user.

### BACKGROUND OF THE INVENTION

Usually, a micro-display intended to be embedded into a portable device, such as a mobile phone or a head mounted device, comprises a matrix of light sources with micron size pixels.

It exists micro-displays comprising a laser source or a light-emitting diode (LED), or three laser sources or LEDs in order to make a colored image, and a microelectromechanical system (MEMS). The MEMS is configured to receive the light emitted by the LED or the laser source and to scan the surface of the eye of the user of the portable device. Such micro-display have a high level of luminosity, but generally require complex laser source and complex optical design.

Moreover, with a micro-display having low luminance, readability problems may occur, especially for augmented reality applications when the luminance of the environment of the wearer is at a high level.

Additionally, if the luminance of the display is set to a high value, the temperature of the elements of the display increases, which causes heat dissipation problems, and may cause a discomfort for the user of the portable device, in particular when the micro-display is embedded into a lens of a head mounted device.

It exists organic light-emitting diode (OLED) displays having a low luminance, liquid crystal displays (LCDs), liquid crystal on silicon (LCOS) sequential color displays and LCOS filter color displays. The LCOS filter color displays comprise one LED, whereas the LCOS sequential color displays comprise three LEDs. Such displays generally have a better luminance than the OLED displays, for instance about 2 kcd/m² or less. However, since the LCOS sequential color displays comprise three LEDs, it requires more space in order to fit the LEDs into a portable device, for instance into a lens of a head mounted device. Moreover, such micro-displays generally require a complex optical guide, especially for augmented reality application, where the optical guide need to be transparent to enable a see-through vision of the user. Additionally, a LCD need one or several LED(s) backlight in order to reflect the light of the LEDs, which require more space in order to fit the display into a lens of a head mounted device. Hence, both the OLED and LCOS displays have a matrix shape and components too large to fit into a portable device easily. Thus, such micro-displays are usually placed on a temple of the head mounted device, with an optical guide to transmit the image to be projected to the eye of the user.

It also exists, micro-light-emitting diode (micro-LED) displays having a high luminosity, for instance about 6000 kcd/m², and a pixel size of about 10 to 20 µm. However, a matrix comprising such micro-LED technology presents heat transfer problems. Moreover, the micro-LED displays have the same size than the OLED and LCOS displays, and thus, such displays are difficult to be integrated into lenses.

US2013208362A1 discloses a laser illumination scanning. WO 2016/105283 A1 discloses a near-to-eye display device with moving light sources. US 2015/126857 A1 discloses an optical probe and medical imaging apparatus including the same. US 5715 021 A discloses methods and apparatus for image projection.

Hence, there is a need for a linear display array of light sources and a projector configured to project the linear array successively at different positions to display a matrix image.

One object of the invention is to provide such projector and linear display array of light sources.

### SUMMARY OF THE INVENTION

To this end, the invention proposes a head mounted device according to claim 1.

The projector according to the invention is embedded into the optical system of the head mounted device. Additionally, the linear array of light sources allows reducing the general size of the projector, and thus allows facilitating the projector to be embedded into the optical system of the head mounted device placed in front of the eye of a user.

Moreover, with the linear array of light sources and the scanning mean, the heat dissipation is reduced.

According to embodiments, the head mounted device according to the invention may further comprise one or several of the following features according to any possible combination:
- the scanning mean comprises a reflecting optic configured to direct the light beam towards an eye of the user, the reflecting optic being movable by rotation such that the rotation of the reflecting optic causes the movement of the light beam according to the second direction to display the image; and/or
- the projector further comprises a light conducting element arranged and configured to guide the light beam emitted by the light sources of the linear array towards the reflecting optic; and/or
- the scanning mean comprises at least a microelectromechanical system (MEMS); and/or
- the projector further comprises a heat dissipator; and/or
- the linear array comprises a first line matrix of light sources emitting at a first wavelength, a second line matrix of light sources emitting at a second wavelength and a third line matrix of light sources emitting at a third wavelength, the line matrix of light sources being arranged along the other ones, the first, second and third wavelengths being different one from the other; and/or
- the first line matrix comprises red diodes, the second line matrix comprises blue diodes and the third line matrix comprises green diodes; and/or
- the linear array comprises one line matrix of light sources emitting at one wavelength; and/or
- the first line matrix comprises red diodes or blue diodes or green diodes; and/or
- the linear array comprises one line matrix of light sources emitting at a first, a second and a third wavelengths, the first, second and third wavelengths being different one from the other; and/or
- the first line matrix comprises red diodes and blue diodes and green diodes; and/or
- the linear array comprises a first line matrix of light sources emitting at a first and a second wavelengths, a second line matrix of light sources emitting at a second and a third wavelengths, the line matrix of light sources being arranged along the other one, the first, second and third wavelengths being different one from the other; and/or
- the first line matrix comprises red diodes and green diodes, and the second line matrix comprises blue diodes and green diodes; and/or
- the head mounted device comprises at least an optical system designed to be placed in front of the eye of the user and having a back face, the projector being embedded into the optical system such that the image projected by the projector is transmitted through the back face towards the eye of the user; and/or
- the projector is arranged such that the linear array extends horizontally or vertically into the optical system; and/or
- the optical system is an ophthalmic lens intended to be worn by the user, the ophthalmic lens being adapted to the user; and/or
- the optical system is an ophthalmic lens intended to be worn by the user, the ophthalmic lens being adapted to the user's prescription; and/or
- one of the at least a projector is arranged in a lower part of the ophthalmic lens and configured to project the image towards the eye with a focus tuned for near vision and/or one of the at least a projector is arranged in an upper part of the ophthalmic lens and configured to project the image towards the eye with a focus tuned for far vision.

Unless specifically stated otherwise, as apparent from the following discussions, it is appreciated that throughout the specification discussions utilizing terms such as "computing", "calculating", or the like, refer to the action and/or processes of a computer or computing system, or similar electronic computing device, that manipulate and/or transform data represented as physical, such as electronic, quantities within the computing system's registers and/or memories into other data similarly represented as physical quantities within the computing system's memories, registers or other such information storage, transmission or display devices.

Embodiments of the present invention may include apparatuses for performing the operations herein. This apparatus may be specially constructed for the desired purposes, or it may comprise a general purpose computer or Digital Signal Processor ("DSP") selectively activated or reconfigured by a computer program stored in the computer. Such a computer program may be stored in a computer readable storage medium, such as, but is not limited to, any type of disk including floppy disks, optical disks, CD-ROMs, magnetic-optical disks, read-only memories (ROMs), random access memories (RAMs) electrically programmable read-only memories (EPROMs), electrically erasable and programmable read only memories (EEPROMs), magnetic or optical cards, or any other type of media suitable for storing electronic instructions, and capable of being coupled to a computer system bus.

In addition, embodiments of the present invention are not described with reference to any particular programming language. It will be appreciated that a variety of programming languages may be used to implement the teachings of the inventions as described herein.

### BRIEF DESCRIPTION OF THE DRAWINGS

Other characteristics and advantages of the invention will become more apparent from the claims and from the following description of some embodiments given by way of example without limitation with reference to the drawings, in which:
- figure 1 represents a projector according to an embodiment not falling under the scope of the invention,
- figures 2a to 2d represent linear arrays of light sources according to embodiments of the invention,
- figure 3 represents a projector according another embodiment not falling under the scope of the invention, and
- figure 4 represents a portable device comprising a projector according to an embodiment of the invention.

Elements in the figures are illustrated for simplicity and clarity and have not necessarily been drawn to scale. For example, the dimensions of some of the elements in the figure may be exaggerated relative to other elements to help improve the understanding of the embodiments of the present invention.

### DETAILED DESCRIPTION OF PREFERRED EMBODIMENTS

The invention relates to a projector intended to be embedded into an optical system of a head mounted device.

The projector is configured to project an image towards an eye of a user.

The projector is preferably a micro-projector.

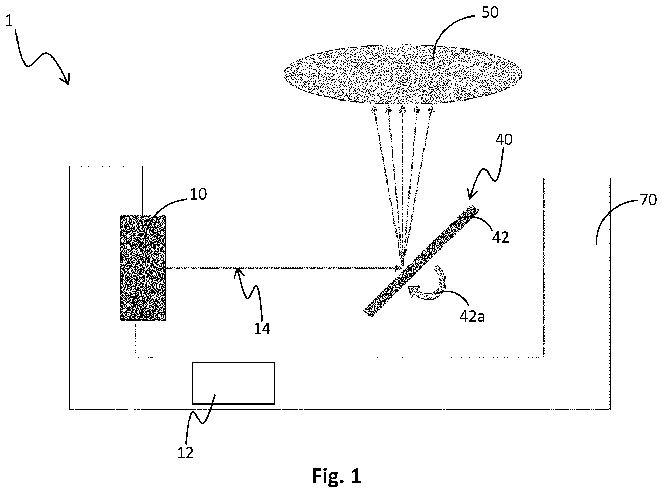

A projector according to an embodiment of the invention is represented in figure 1. The projector 1 comprises a linear array 10 of light sources, a scanning mean 40 and a control unit 12.

The linear array 10 of light sources extends in a first direction and is configured to emit a light beam 14.

The scanning mean 40 is configured to move the light beam 14 in a second direction transverse to the first direction to display the image. More precisely, the light beam 14 is redirected by the scanning mean 40 in a second direction. The scanning mean 40 allows displaying the image towards an eye of a user.

The control unit 12 is configured to control the scanning mean 40 and the light sources of the linear array 10.

The projector is a double piece projector. In particular, in a double piece projector, the light beam 14 emitted by the linear array 10 of light sources is guided towards the scanning mean 40, for instance with an optical guide. In other words, the linear array 10 and the scanning mean 40 may be separated by an optical guide.

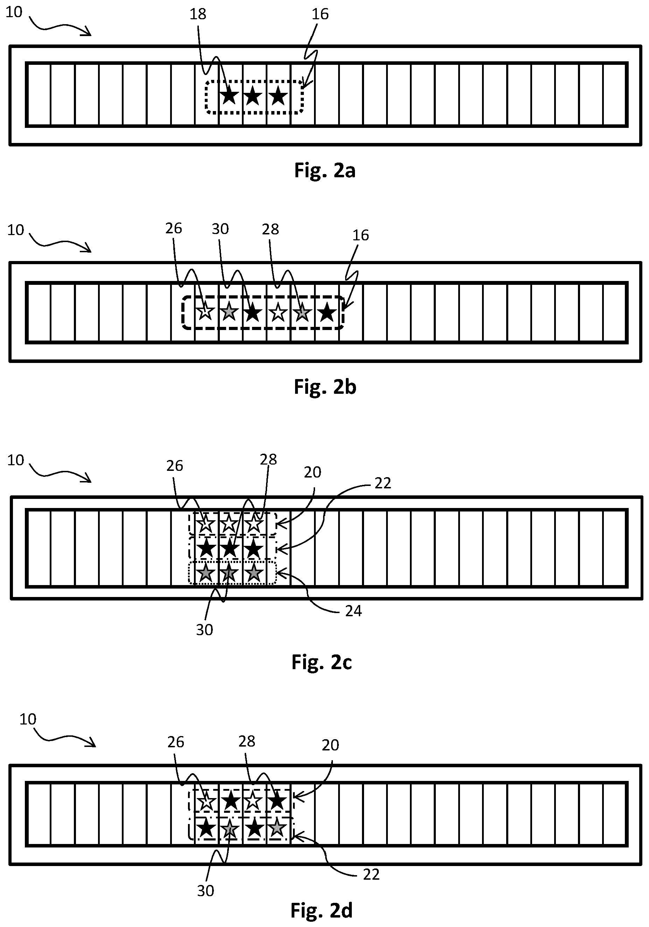

According to an embodiment of the invention represented in figure 2a, the linear array 10 may comprise one line matrix 16 of light sources extending in a first direction and emitting at a first wavelength. In other words, the linear array is a single color array of light sources aligned along a first direction.

Advantageously, the first wavelength is comprised in the visible spectrum, namely between 400 nm and 700 nm. With such linear array 10, the image projected by the projector 1 is a monochrome image.

The line matrix 16 may comprise laser diodes or micro-LEDs 18. The diodes 18 may be red, or blue, or green diodes.

The line matrix 16 may comprise a plurality of diodes, depending on the size and the resolution of the image to be projected. For instance, a line matrix may comprise 2048 micro-LEDs. Each micro-LED may be about 10 µm, namely a line matrix may be about 20.48 mm wide. Advantageously, such line matrix is sized small enough to fit into a mobile phone or into a lens of a head mounted device easily.

According to an embodiment of the invention represented in figure 2b, the linear array 10 may comprise one line matrix 16 of light sources emitting at a first, a second and a third wavelengths, the first, second and third wavelengths being different one from the other.

As illustrated in figure 2b, the line matrix 16 may comprise red diodes 26, blue diodes 28 and green diodes 30.

Such configuration allows obtaining a colored image.

According to another embodiment of the invention represented in figure 2c, the linear array 10 may comprise a first line matrix 20 of light sources, a second line matrix 22 of light sources and a third line matrix 24 of light sources.

The line matrix are preferably arranged along the other ones. In other words, the first line matrix 20, the second line matrix 22 and the third line matrix 24 are aligned one beside the other ones.

In particular, the first line matrix 20 emits at a first wavelength, the second line matrix 22 emits at a second wavelength and the third line matrix 24 emits at a third wavelength, with the first, second and third wavelengths different one from the other. Advantageously, the first, second and third wavelengths may be comprised in the visible spectrum. Preferably, a difference of wavelength between each of the first, second and third wavelengths is greater than 30 nm.

In other words, with such linear array 10, when the first, second and third wavelengths correspond to the red, blue and green colors, the image projected by the projector 1 is a colored image.

As represented in figure 2c, the first line matrix 20 may comprise red diodes 26, the second line matrix 22 may comprise green diodes 30 and the third line matrix 24 may comprise blue diodes 28. Of course, the first, second and third line array may be interchanged. Generally, the first, second and third lines matrix comprise the same number of light sources, so as to project an image without errors.

The first, second and third line matrix may comprise micro-LEDs. For instance, the height of the three lines of micro-LEDs may be about 30 µm. Advantageously, such lines matrix is sized small enough to fit into a mobile phone or into a head mounted device easily.

According to an embodiment of the invention, the first line matrix of light sources may be turned on, and then the second line matrix of light sources may be turned on, and then the third line matrix of light sources may be turned on. Each line matrix may be scanned by the scanning means.

According to another embodiment of the invention represented in figure 2d, the linear array 10 of light sources may comprise a first line matrix 20 of light sources emitting at a first and a second wavelengths, and a second line matrix 22 of light sources emitting at a second and a third wavelengths, with the first, second and third wavelengths different one from the other. The line matrix of light sources being arranged along the other one.

As illustrated in figure 2d, the first line matrix 20 may comprise red diodes 26 and green diodes 30, and the second line matrix 22 may comprise blue diodes 28 and green diodes 30. Of course, the first and second lines matrix may comprise any combination of diodes comprising red, blue, green or white diodes.

According to an embodiment not falling under the scope of the claimed invention illustrated in figure 1, the scanning mean 40 may comprise a reflecting optic 42 configured to direct the light beam 14 towards a surface 50 reflecting light towards an eye of the user. In particular, the reflecting optic 42 may be movable by rotation, the rotational movement being represented by the arrow 42a. The rotation of the reflecting optic 42 causes the movement of the light beam 14 according to the second direction to display the image.

The reflecting optic may be, for example, a reflecting mirror.

According to a further embodiment not falling under the scope of the claimed invention, the scanning mean 40 may comprise a microelectromechanical system (MEMS) configured to direct the light beam 14 towards a surface 50 reflecting light towards an eye of the user.

The reflecting optic 42 may comprise the MEMS. Advantageously, the scanning mean 40 comprising a reflecting mirror, the reflecting mirror being a MEMS, the projector presents a thin thickness.

According to a further embodiment not falling under the scope of the claimed invention, the scanning mean 40 may comprise a controllable liquid optic configured to direct the light beam 14 to display the image. The controllable liquid optic is preferably controlled by the control unit 12. More precisely, the controllable liquid optic is controlled with an electric field. The controllable liquid optic is designed so as to cover the linear array and to direct the light beam in the second direction.

According to a further embodiment not falling under the scope of the claimed invention, the scanning mean 40 may comprise an electro-active optic configured to direct the light beam 14 to display the image. The electro-active optic is preferably controlled by the control unit 12.

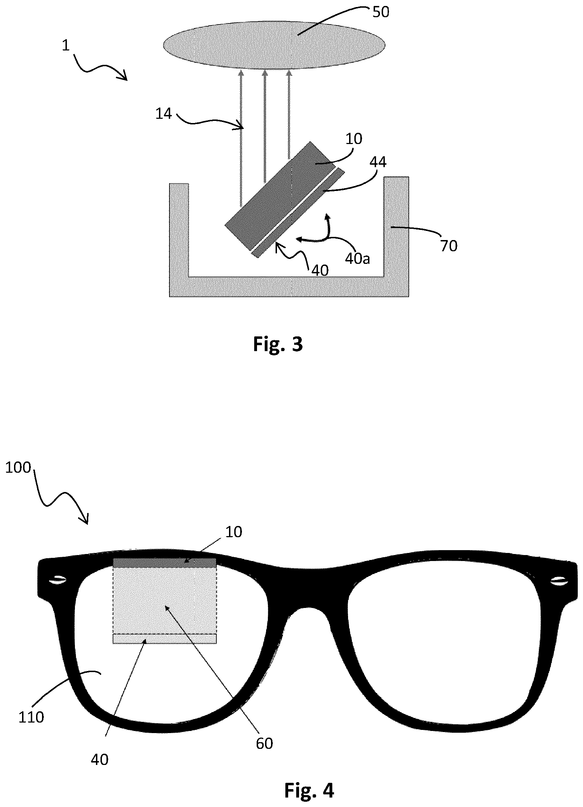

According to a further embodiment not falling under the scope of the claimed invention illustrated in figure 3, the scanning mean 40 may comprise a support 44 configured to support the linear array 10 of light sources. The support 44 is movable by rotation, the rotational movement being represented by the arrow 44a. The rotation of the support 44 causes the movement of the light beam 14 according to the second direction to display the image. More precisely, the rotation of the support 44 causes the rotation of the linear array 10 of light sources, so that the light beam 14 emitted by the light sources of the linear array 10 display the image.

The support 44 is advantageously designed with a shape similar to the shape of the linear array 10.

The scanning mean 40 may further comprise an optical element configured to direct the light beam 14 into the second direction to display the image. The scanning mean 40, the linear array 10 and the optical element are movable together in rotation to direct the light beam 14 into the second direction so as to display the image.

According to the invention, the projector 1 comprises a light conducting element arranged and configured to guide the light beam 14 emitted by the light sources of the linear array 10 towards the scanning mean 40, and more precisely towards the reflecting optic 42.

The light conducting element 60, represented in figure 4, may be a transparent optical guide.

In the claimed invention, the projector 1 is a double piece projector. The linear array 10 is separated from the scanning mean 40 by the light conducting element 60.

The projector 1 may further comprise a focusing optic for focusing the light beam guided by the light conducting element at a predetermined distance. For instance, the focusing optic may be arranged to receive the light beam and to focus it on the scanning means 40.

According to a further embodiment of the invention, the projector 1 may comprise a mechanical support 70.

The mechanical support 70 is configured to support the linear array 10, the scanning mean 40 and the control unit 12.

The projector 1 may further comprise a heat dissipator. Preferably, the mechanical support 70 comprises the heat dissipator. The heat dissipator allows reducing the temperature of the projector 1, especially when the linear array 10 comprises micro-LEDs.

Advantageously, the heat dissipator is about 2 mm or less, so that the projector 1 may be embedded easily in a lens of a head mounted device.

The invention further relates to a head mounted device comprising a projector for projecting an image towards an eye of a user as described previously. In other words, the projector of the invention is embedded into an optical system of the head mounted device.

The head mounted device is intended to be worn by a user.

For example, the projector may be embedded into an augmented reality equipment, such as augmented reality lenses with a transparent optical guide.

As another example, the projector may be embedded into a virtual reality equipment comprising a linear array adapted to give a very large field of view. For instance, the linear array may comprise 8000 micro-LEDs and extend over 80 mm wide.

As represented in figure 4, the head mounted device 100 may be a pair of spectacle lenses.

The terms "upper", "lower", "horizontal", "vertical", "temporal side" and "nasal side" are to be understood in wearing conditions of the head mounted device 100, namely such terms indicate relative position of the head mounted device 100 when it is worn by a user.

The head mounted device 100 may comprise a frame and an optical system 110 designed to be placed in front of the eye of a user.

The optical system 110 may be an optical lens, or an ophthalmic lens, intended to be worn by the user. Preferably, the ophthalmic lens is adapted to the user, or to the user's prescription.

The optical system 110 has a back face. The projector 1 is embedded into the optical system 110 such that the image projected by the projector 1 is transmitted through the back face of the optical system 110 towards the eye of the user.

According to an embodiment of the invention, the projector 1 may be arranged such that the linear array 10 extends horizontally into the optical system 110. Advantageously, a linear array 10 extending horizontally into the optical system 110 is placed along the upper edge or the lower edge of the optical system 110.

Alternatively, the projector 1 may be arranged such that the linear array 10 extends vertically into the optical system 110. Advantageously, a linear array 10 extending vertically into the optical system 110 is placed along the nasal edge or the temporal edge of the optical system 110.

According to an embodiment of the invention, the projector 1 may be arranged in a lower part of the ophthalmic lens 110. In particular, in such embodiment, the projector 1 may be configured to project the image towards the eye with a focus tuned for near vision.

In such embodiment, the image projected to the eye of the user is seen by the user only when the user is looking down. In other words, the image is projected in a lower part of the ophthalmic lens 110.

Advantageously, such embodiment allows the user to not be distracted by the projected image. Such embodiment is particularly advantageous when a user is carrying on an activity, such as driving a car.

According to another embodiment of the invention, the projector 1 may be arranged in an upper part of the ophthalmic lens 110. In particular, in such embodiment, the projector 1 may be configured to project the image towards the eye with a focus tuned for far vision.

For a double piece projector, the linear array 10 may be placed horizontally along the upper edge of the ophthalmic lens 110, as represented in figure 4, and the scanning mean 40 may be place around the middle of the ophthalmic lens 110. In particular, the light conducting element 60 may be placed between the linear array 10 and the scanning mean 40, in the upper part of the ophthalmic lens 110. The scanning mean may be placed in front of the field of view of the user. In such embodiment, the scanning mean may be configured to move the light beam emitted by the linear array 10 directly on the direction of the eye of the user.

According to a further embodiment of the invention, the projector 1 may be placed around the middle of the ophthalmic lens 110. In particular, a projector 1 may comprise scanning mean 40 comprising a MEMS mirror so as to direct the light beam on the direction of the eye of the user to display the image. More precisely, the MEMS mirror may be placed in front of the eye of the user without causing discomfort to the user.

For instance, such scanning mean 40 may be about 1 mm, and thus may be integrated in the ophthalmic lens 110 of the head mounted device 100 with transparent connection wires, such as transparent conducting films, or silver nanowires, or any transparent plastic electronic technology used to connect such scanning mean 40 in the middle of an ophthalmic lens 110. Such embodiment is particularly advantageous for augmented reality applications.

The projector may be a thin and transparent micro-display easily integrated into a head mounted device.

The projector may comprise a linear array of light sources emitting a light beam and a scanning mean configured to circularly move the light beam. The circular movement of the scanning mean allows obtaining a circular display.

The linear array of light sources allows making a thin one-axis display, configured to display on one axis when the scanning mean is static and to display a circular image when the scanning mean rotates.

The light sources may be as small as 10 µm. Advantageously, a projector having such light sources allows having a better resolution of the image projected, and a small form factor allowing to integrate the display in a near to eye display.

The projector may comprise a connector configured to connect the linear array of light sources and a control system. The connector may transfer power supply and data to be displayed. The connector may transfer power and data with wireless transmission to the linear array of light sources. The linear array of light sources may comprise a reception antenna coupled with an emission antenna, such as a transparent emission antenna, placed on the connector. The power and data may be received by the linear array of light sources by high frequency radio signal, such as radio frequency identification (RFID) technology.

The invention has been described above with the aid of embodiments without limitation of the general inventive concept. Moreover, the embodiments of the invention may be combined without any restriction.

Many further modifications and variations will suggest themselves to those skilled in the art upon making reference to the foregoing illustrative embodiments, which are given by way of example only and which are not intended to limit the scope of the invention, that being determined solely by the appended claims.

In the claims, the word "comprising" does not exclude other elements or steps, and the indefinite article "a" or "an" does not exclude a plurality. The mere fact that different features are recited in mutually different dependent claims does not indicate that a combination of these features cannot be advantageously used. Any reference signs in the claims should not be construed as limiting the scope of the invention.

## Claims

1. A head mounted device (100) comprising:
- at least an optical system (110) designed to be placed in front of an eye of a user and having a back face, and
- at least one projector (1) embedded into the optical system (110) and configured to project an image through the back face of the optical system towards the eye of the user, the projector comprising:
• a linear array (10) of light sources emitting a light beam (14), the linear array (10) of light sources emitting at at least a first wavelength and extending in a first direction;
• a scanning mean (40) configured to move the light beam (14) in a second direction transverse to the first direction to display the image, wherein the scanning mean (40) comprises a reflecting optic (42) configured to direct the light beam (14) towards the eye of the user, the reflecting optic (42) being movable by rotation such that the rotation of the reflecting optic (42) causes the movement of the light beam (14) in the second direction to display the image;
• a control unit (12) for controlling the scanning mean (40) and the light sources of the linear array (10), and
• a light conducting element (60) arranged and configured to guide the light beam (14) emitted by the light sources of the linear array (10) towards the reflecting optic (42).

2. The head mounted device according to claim 1, wherein the projector (1) is arranged such that the linear array (10) extends horizontally or vertically into the optical system (110).

3. The head mounted device according to claim 1 or 2, wherein the optical system (110) is an ophthalmic lens intended to be worn by the user, the ophthalmic lens being adapted to the user.

4. The head mounted device according to claim 3, wherein one of the at least one projector (1) is arranged in a lower part of the ophthalmic lens and configured to project the image towards the eye with a focus tuned for near vision and/or one of the at least one projector (1) is arranged in an upper part of the ophthalmic lens and configured to project the image towards the eye with a focus tuned for far vision.

5. The head mounted device according to any of the preceding claims, further comprising a heat dissipator.

6. The head mounted device according to claim 5, wherein the heat dissipator is configured to allow reducing the temperature of the at least one projector (1).

7. The head mounted device according to claim 5 or 6, wherein the heat dissipator is about 2 mm or less.

8. The head mounted device according to any of the preceding claims, wherein the scanning mean (40) comprises at least a microelectromechanical system (MEMS).

9. The head mounted device according to any of the preceding claims, wherein the linear array (10) comprises a first line matrix (20) of light sources emitting at a first wavelength, a second line matrix (22) of light sources emitting at a second wavelength and a third line matrix (24) of light sources emitting at a third wavelength, the line matrices of light sources being arranged parallel to each other, the first, second and third wavelengths being different from each other.

10. The head mounted device according to claim 9, wherein the first line matrix (20) comprises red diodes, the second line matrix (22) comprises blue diodes and the third line matrix (24) comprises green diodes.

11. The head mounted device according to any of claims 1 to 8, wherein the linear array (10) comprises a first line matrix of light sources emitting at a first and a second wavelengths, and a second line matrix of light sources emitting at a second and a third wavelengths, the line matrices of light sources being arranged parallel to each other, the first, second and third wavelengths being different from each other.

12. The head mounted device according to claim 11, wherein the first line matrix comprises red diodes and green diodes, and the second line matrix comprises blue diodes and green diodes.

## Patentansprüche

1. Kopfmontierte Vorrichtung (100), die Folgendes umfasst:
- wenigstens ein optisches System (110), das dazu gestaltet ist, vor einem Auge eines Benutzers platziert zu werden, und das eine hintere Fläche aufweist, und
- wenigstens einen Projektor (1), der in das optische System (110) eingebettet ist und dazu konfiguriert ist, ein Bild durch die hintere Fläche des optischen Systems zu dem Auge des Benutzers hin zu projizieren, wobei der Projektor Folgendes umfasst:
• ein lineares Array (10) von Lichtquellen, die einen Lichtstrahl (14) emittieren, wobei das lineare Array (10) von Lichtquellen mit wenigstens einer ersten Wellenlänge emittiert und sich in einer ersten Richtung erstreckt;
• ein Scanmittel (40), das dazu konfiguriert ist, den Lichtstrahl (14) in einer zweiten Richtung quer zu der ersten Richtung zu bewegen, um das Bild anzuzeigen, wobei das Scanmittel (40) eine reflektierende Optik (42) umfasst, die dazu konfiguriert ist, den Lichtstrahl (14) zu dem Auge des Benutzers hin zu lenken, wobei die reflektierende Optik (42) durch Drehung derart beweglich ist, dass die Drehung der reflektierenden Optik (42) bewirkt, dass die Bewegung des Lichtstrahls (14) in der zweiten Richtung das Bild anzeigt;
• eine Steuereinheit (12) zum Steuern des Scanmittels (40) und der Lichtquellen des linearen Arrays (10), und
• ein Lichtleitungselement (60), das dazu eingerichtet und konfiguriert ist, den Lichtstrahl (14), der durch die Lichtquellen des linearen Arrays (10) emittiert wird, zu der reflektierenden Optik (42) hin zu leiten.

2. Kopfmontierte Vorrichtung nach Anspruch 1, wobei der Projektor (1) derart angeordnet ist, dass sich das lineare Array (10) horizontal oder vertikal in das optische System (110) erstreckt.

3. Kopfmontierte Vorrichtung nach Anspruch 1 oder 2, wobei das optische System (110) eine ophthalmische Linse ist, die zum Tragen durch den Benutzer vorgesehen ist, wobei die ophthalmische Linse an den Benutzer angepasst ist.

4. Kopfmontierte Vorrichtung nach Anspruch 3, wobei einer des wenigstens einen Projektors (1) in einem unteren Teil der ophthalmischen Linse angeordnet und dazu konfiguriert ist, das Bild mit einem auf Nahsicht abgestimmten Fokus zu dem Auge hin zu projizieren, und/oder einer des wenigstens einen Projektors (1) in einem oberen Teil der ophthalmischen Linse angeordnet und dazu konfiguriert ist, das Bild mit einem auf Fernsicht abgestimmten Fokus zu dem Auge hin zu projizieren.

5. Kopfmontierte Vorrichtung nach einem der vorhergehenden Ansprüche, die ferner einen Wärmeableiter umfasst.

6. Kopfmontierte Vorrichtung nach Anspruch 5, wobei der Wärmeableiter dazu konfiguriert ist, zu ermöglichen, die Temperatur des wenigstens einen Projektors (1) zu reduzieren.

7. Kopfmontierte Vorrichtung nach Anspruch 5 oder 6, wobei der Wärmeableiter etwa 2 mm oder weniger groß ist.

8. Kopfmontierte Vorrichtung nach einem der vorhergehenden Ansprüche, wobei das Scanmittel (40) wenigstens ein mikroelektromechanisches System (MEMS) umfasst.

9. Kopfmontierte Vorrichtung nach einem der vorhergehenden Ansprüche, wobei das lineare Array (10) eine erste Zeilenmatrix (20) von Lichtquellen, die mit einer ersten Wellenlänge emittieren, eine zweite Zeilenmatrix (22) von Lichtquellen, die mit einer zweiten Wellenlänge emittieren, und eine dritte Zeilenmatrix (24) von Lichtquellen, die mit einer dritten Wellenlänge emittieren, umfasst, wobei die Zeilenmatrizen von Lichtquellen parallel zueinander angeordnet sind, wobei sich die erste, zweite und dritte Wellenlänge voneinander unterscheiden.

10. Kopfmontierte Vorrichtung nach Anspruch 9, wobei die erste Zeilenmatrix (20) rote Dioden umfasst, die zweite Zeilenmatrix (22) blaue Dioden umfasst und die dritte Zeilenmatrix (24) grüne Dioden umfasst.

11. Kopfmontierte Vorrichtung nach einem der Ansprüche 1 bis 8, wobei das lineare Array (10) eine erste Zeilenmatrix von Lichtquellen, die mit einer ersten und einer zweiten Wellenlänge emittieren, und eine zweite Zeilenmatrix von Lichtquellen, die mit einer zweiten und einer dritten Wellenlänge emittieren, umfasst, wobei die Zeilenmatrizen von Lichtquellen parallel zueinander angeordnet sind, wobei sich die erste, zweite und dritte Wellenlänge voneinander unterscheiden.

12. Kopfmontierte Vorrichtung nach Anspruch 11, wobei die erste Zeilenmatrix rote Dioden und grüne Dioden umfasst und die zweite Zeilenmatrix blaue Dioden und grüne Dioden umfasst.

## Revendications

1. Dispositif monté sur la tête (100) comprenant :
- au moins un système optique (110) conçu pour être placé devant un œil d'un utilisateur et ayant une face arrière, et
- au moins un projecteur (1) intégré dans le système optique (110) et configuré pour projeter une image à travers la face arrière du système optique vers l'œil de l'utilisateur, le projecteur comprenant :
• un réseau linéaire (10) de sources de lumière émettant un faisceau lumineux (14), le réseau linéaire (10) de sources de lumière émettant à au moins une première longueur d'onde et s'étendant dans une première direction ;
• un moyen de balayage (40) configuré pour déplacer le faisceau lumineux (14) dans une deuxième direction transversale à la première direction afin d'afficher l'image, le moyen de balayage (40) comprenant une optique réfléchissante (42) configurée pour diriger le faisceau lumineux (14) vers l'œil de l'utilisateur, l'optique réfléchissante (42) étant mobile par rotation, de sorte que la rotation de l'optique réfléchissante (42) provoque le déplacement du faisceau lumineux (14) dans la deuxième direction pour afficher l'image ;
• une unité de commande (12) destinée à commander le moyen de balayage (40) et les sources de lumière du réseau linéaire (10), et
• un élément conducteur de lumière (60) agencé et configuré pour guider le faisceau lumineux (14) émis par les sources de lumière du réseau linéaire (10) vers l'optique réfléchissante (42).

2. Dispositif monté sur la tête selon la revendication 1, dans lequel le projecteur (1) est agencé de telle sorte que le réseau linéaire (10) s'étend horizontalement ou verticalement à l'intérieur du système optique (110).

3. Dispositif monté sur la tête selon la revendication 1 ou 2, dans lequel le système optique (110) est une lentille ophtalmique destinée à être portée par l'utilisateur, la lentille ophtalmique étant adaptée à l'utilisateur.

4. Dispositif monté sur la tête selon la revendication 3, dans lequel le projecteur ou un des projecteurs (1) est disposé dans une partie inférieure de la lentille ophtalmique et configuré pour projeter l'image vers l'œil avec un foyer réglé pour la vision de près et/ou le projecteur ou un des projecteurs (1) est disposé dans une partie supérieure de la lentille ophtalmique et configuré pour projeter l'image vers l'œil avec un foyer réglé pour la vision de loin.

5. Dispositif monté sur la tête selon l'une quelconque des revendications précédentes, comprenant en outre un dissipateur thermique.

6. Dispositif monté sur la tête selon la revendication 5, dans lequel le dissipateur thermique est configuré pour permettre la réduction de la température de l'au moins un projecteur (1).

7. Dispositif monté sur la tête selon la revendication 5 ou 6, dans lequel le dissipateur thermique fait environ 2 mm ou moins.

8. Dispositif monté sur la tête selon l'une quelconque des revendications précédentes, dans lequel le moyen de balayage (40) comprend au moins un système microélectromécanique (MEMS).

9. Dispositif monté sur la tête selon l'une quelconque des revendications précédentes, dans lequel le réseau linéaire (10) comprend une première matrice linéaire (20) de sources de lumière émettant à une première longueur d'onde, une deuxième matrice linéaire (22) de sources de lumière émettant à une deuxième longueur d'onde et une troisième matrice linéaire (24) de sources de lumière émettant à une troisième longueur d'onde, les matrices linéaires de sources de lumière étant disposées parallèlement les unes aux autres, les première, deuxième et troisième longueurs d'onde étant différentes les unes des autres.

10. Dispositif monté sur la tête selon la revendication 9, dans lequel la première matrice linéaire (20) comprend des diodes rouges, la deuxième matrice linéaire (22) comprend des diodes bleues et la troisième matrice linéaire (24) comprend des diodes vertes.

11. Dispositif monté sur la tête selon l'une quelconque des revendications 1 à 8, dans lequel le réseau linéaire (10) comprend une première matrice linéaire de sources de lumière émettant à une première et une deuxième longueur d'onde, et une deuxième matrice linéaire de sources de lumière émettant à une deuxième et une troisième longueur d'onde, les matrices linéaires de sources de lumière étant disposées parallèlement l'une à l'autre, les première, deuxième et troisième longueurs d'onde étant différentes les unes des autres.

12. Dispositif monté sur la tête selon la revendication 11, dans lequel la première matrice linéaire comprend des diodes rouges et des diodes vertes, et la deuxième matrice linéaire comprend des diodes bleues et des diodes vertes.
